Europäisches Patentamt

European Patent Office

Office européen des brevets

(11) Publication number:

**0 321 239**
**A2**

## (12) EUROPEAN PATENT APPLICATION

(21) Application number: 88311869.7

(22) Date of filing: 15.12.88

(51) Int. Cl.⁴: **H 01 L 21/60**

(30) Priority: 17.12.87 JP 319444/87

(43) Date of publication of application:
21.06.89 Bulletin 89/25

(84) Designated Contracting States: DE FR GB

(71) Applicant: Matsushita Electric Industrial Co., Ltd.
1006, Oaza Kadoma
Kadoma-shi Osaka-fu, 571 (JP)

(72) Inventor: Fujimoto, Hiroaki
14-9, Sakuragi-cho Korien
Hirakata-shi Osaka (JP)

Hatada, Kenzo
4-8-3, Nanseidai
Katano-shi Osaka (JP)

Ochi, Takeo
3-11-15, Minami-Sumiyoshi Sumiyoshi-ku
Osaka-shi Osaka (JP)

(74) Representative: Crawford, Andrew Birkby et al
A.A. THORNTON & CO. Northumberland House 303-306
High Holborn
London WC1V 7LE (GB)

(54) Fabricating method of semiconductor device.

(57) This invention relates to mounting of LSI chip of multiple electrodes and narrow pitch such as gate array and microcomputer. In a semiconductor device having an LSI chip with bump electrode affixed to a wiring board by means of insulation resin, and the bump electrode of the LSI chip electrically connected by the contact between the wiring board and conductor wiring, by mounting with the bump electrode in a state of elastic deformation, both heat resistance and productivity are enhanced, and a semiconductor device of high reliability and low cost is obtained.

EP 0 321 239 A2

Description

## FABRICATING METHOD OF SEMICONDUCTOR DEVICE

This invention relates to a fabricating method of semiconductor device, and more particularly to a mounting method of LSI chips of multiple electrodes and narrow pitch in microcomputer, gate array, etc.

The present inventors already proposed the following method as a method suited to mounting of such devices (Japanese Ladi-Open Patent No. 60-262430, corresponding to U.S. Application No. 943.197, now issued as U.S.P. 4,749,120).

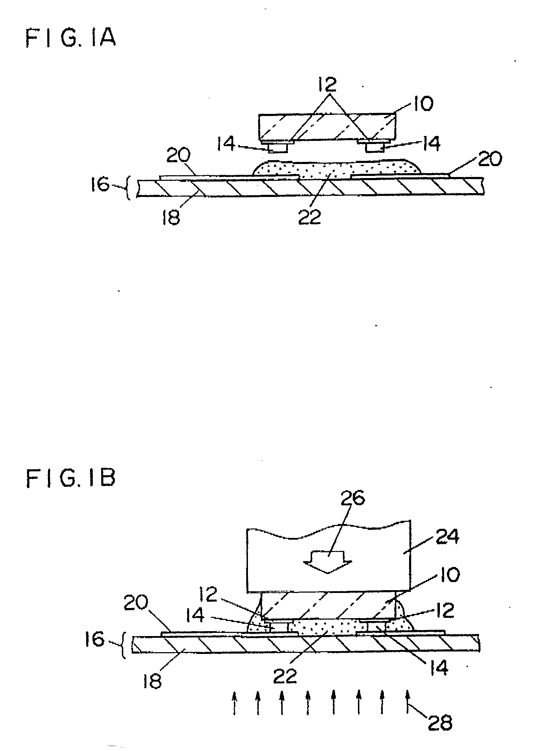

An example of the previously proposed art is described with reference to FIG. 1. A semiconductor device (e.g., an IC chip) is designated by numeral 10. A multi-layer metal film is formed and fixed on each electrode pad 12 of semiconductor device 10. The multi-layer metal film is made by Cr-Cu, Ti-Pd, etc. Metal projection or metal bump 14 is formed on each electrode pad 12 by conventional electro-plating method. The metal bump 14 is made by Au, Ag, Cu solder, etc. and its thickness is 3-30 µm.

On the other hand, a wiring board is designated by numeral 16. The wiring board 16 includes base 18 and wiring pattern 20 which is formed on the base 18. The base 18 is made by glass, ceramic, resin or, metal whose surface is covered by metal oxide, and so on. The wiring patterns 20 are formed on a surface of base 18 and designed to receive corresponding metal bumps 14 of semiconductor device 10. The wiring patterns 20 include, as principal material, Cu, Aℓ, Au, ITO, etc., and for example, when Cu (which is readily oxidized) is selected as principal material, Au plating, Sn plating, solder plating, etc. is applied thereto.

Further, insulating synthetic resin 22 is disposed on wiring board 16 at the position to which semiconductor device 10 is attached. The resin 22 may be disposed on a bottom surface of semiconductor device 10. The resin 22 may be liquid or sheet material, and solidified by light or heat. The resin 22 may be a modified acrylate.

The semiconductor device 10 is held by a movable tool 24 and positions o metal bumps 14 are adjusted to be in correspondence with wiring patterns 20 of wiring board 16. Then, metal bumps 14 are pressed against wiring pattern 20 by downward movement of tool 24 in the direction of arrow 26. By this pressure applied in the direction of arrow 26, resin 22, which is disposed between metal bump 14 and wiring pattern 20, is pressed to be expanded outwardly so that resin 22 is removed from the area between metal bump 14 and wiring pattern 20 and metal bumps 14 are electrically connected to wiring pattern 20.

In this position, light or heat 28 is applied to resin 22. Thereby, resin 22 is stiffened or solidified. By such stiffened resin 22, semiconductor device 10 and wiring baord 16 are fixed with metal bumps 14 being electrically connected to wiring patterns 20. Thereafter, light or heat (28) application is stopped and then, pressure (26) application is removed.

As explained above, in the first embodiment, the electrical connection of metal bumps 14 of semiconductor device 10 and wiring pattern 20 of wiring board 16 is accomplished by the application of pressure, and the fixing of semiconductor device 10 and wiring board 16 is accomplished by stiffened resin.

The resin 22 is of a modified acrylate group. In the case that resin 22 is stiffened by light, the stiffening operation is completed by the application of ultraviolet light of 300-400 nm for approximately 20-60 seconds at an energy of 20 mW/cm$^2$. In the case of stiffening by use of heat, the stiffening operation is completed by application of heat whose temperature is 100°-150° for 5-30 minutes. In these cases, given a surface zie of metal pump 14 is 70x70 µm and metal bump 14 being made of Au, electrical resistance of the connection portion becomes approximately 1-10 mohms.

If insulating resin 22 is of a combination type, e.g., light stiffening and natural stiffening, light application may be carried out both from the semiconductor device side (upper side in FIG. 1) and from the wiring board side (lower side) because, even if an unstiffened portion of resin 22 remains; it is stiffened by the lapse of time.

If insulating resin 22 is of another combination type, e.g. light stiffening and heat stiffening, a part of the resin is stiffened by light application so that semiconductor device 10 and wiring board 16 are temporarily fixed, and thereafter, they are completely fixed by heat application.

If these cases, fixing can be accomplished with a higher reliability by the use of pressure application when unstiffened resin is stiffened at normal temperature or by heating after light application is completed. In this case, there arises no problem even if the pressure to be applied is less than that upon light application.

It is hence a primary object of this invention to further enhance the reliability and productivity of the above proposal.

To achieve this object, the fabricating method of semiconductor device of this invention is to keep the bump electrode of LSI chip in elastic deformation when pressing the LSI chip to a wiring board, and to connect the bump electrode of the LSI chip and the conductor wiring.

This invention possesses the following advantages. Since the bump electrode of the LSI chip is set in contact with the conductor wiring of the wiring board in an elastic deformation state, if a dimensional change due to thermal expansion occurs in the insulating resin, or if a dimensional change between the LSI chip and wiring board occurs, the bump electrodes recovers elastically, so that the contact state of the bump electrode and conductor wiring may be always maintained, and the heat resistance and reliability may be high. It is hence possible to apply into power device or the like.

FIG. 1 shows an example of the previously proposed art;

FIG. 2 shows an embodiment of this invention; and

FIG.3 shows a state of elastic deformation of the bump electrode in this invention.

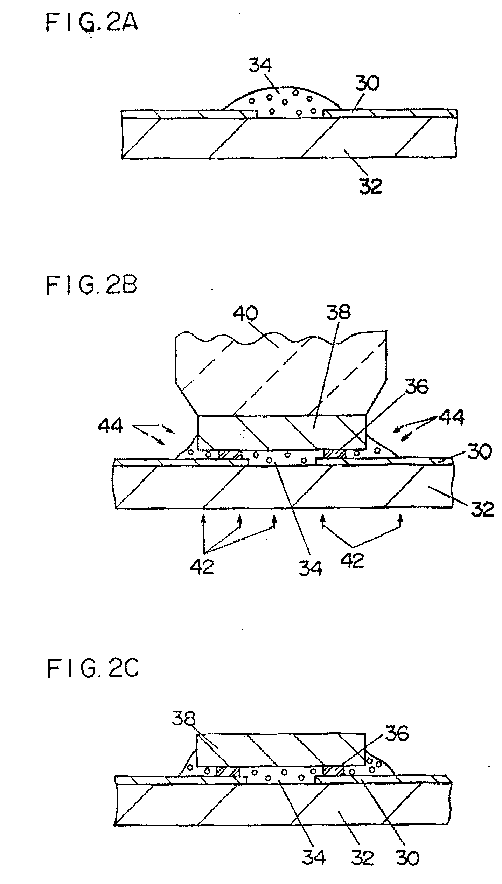

An embodiment of the invention is described below while referring to FIG. 2.

First, as shown in FIG. 2A, a light- or heat-stiffening insulating resin 34 is applied in a region containing a conductor wiring 30 of wiring board 32 possessing a conductor wiring 30 made of glass or ceramic. The thickness of the wiring board 32 is about 0.1 to 2.0 mm, and the conductor wiring 30 is CR-Au, A$\ell$, ITO, etc., and its thickness is about 0.1 to 10 μm. The insulating resin 34 is an acrylic, epoxy or similar material which is stiffened by ultraviolet rays or both ultraviolet rays and heat, and it is applied by dispenser, screen printing or other means. Next, as shwon in FIG. 2B, an LSI chip 38 having a bump electrode 36 made of Au or the like is disposed in a region coated with the insualting resin 34 of the wiring board 32 so that the bump electrode 36 and the conductor wiring 30 may coincide with each other.

The thickness of the bump electrode 36 is about 5 to 30 μm, and its dimension is about 3 to 50 μm square. In order to keep the bump electrode 36 in an elastic deformation state, the LSI chip 38 is pressed by a pressing tool 40. The pressure is about 0.5 g/electrode to 5 g/electrode.

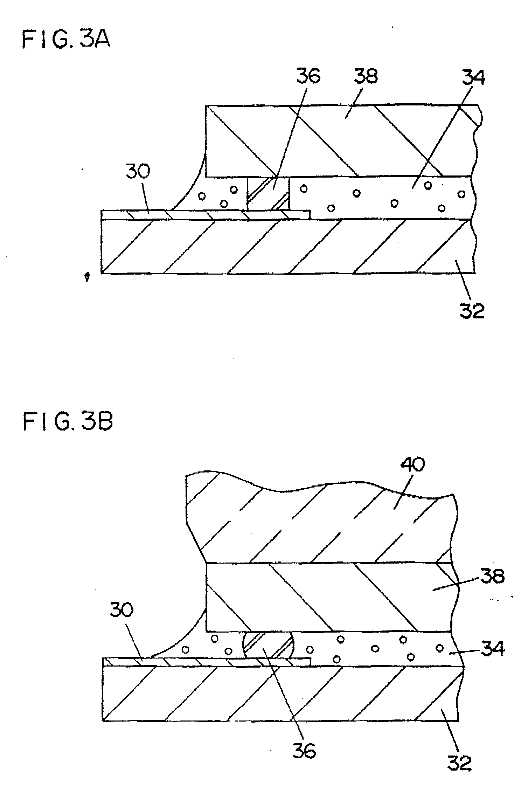

The state of elastic deformation of the bump electrode 36 is shown in FIGS. 3A, 3B. FIG. 3A shows the LSI chip 38 being placed at the position of the wiring board 32, and FIG. 3B denotes the state of pressing the LSI chip 38 and elastically deforming the bump electrode 36. Since the bump electrode 36 is in an elastic deformation state, if the insulating resin 34 is later stiffened and relieved, a restoring force acts on the bump electrode 36, and the contact pressure of the bump electrode f36 on the conductor wiring 30 is strong, and it also follows up the dimensional change due to expansion of the insulating resin 36 after stiffening, the contact resistance remains high even at high temperature, and a high reliability is obtained.

At this time, the insulating resin 34 is forced outward, and the bump electrode 36 of the LSI chip 38 and the conductor wiring 30 electrically contact with each other.

Next, with the LSI chip 38 being pressed, the insulating resin 34 is heated, and is irradiated with ultraviolet rays 42, 44 at the same time to stiffen the insulating resin 34. If the wiring board 32 is a glass, it is irradiated with ultraviolet rays 42, or if it is an opaque board such as ceramic, the side face of the LSI chip 38 is irradiated with ultraviolet ray 44. To heat the insulating resin 34, a heating mechanism is installed, for example, in the pressing tool 40. Or it may be also possible to heat easily by using infrared rays or hot air. In this way, by irradiating with ultraviolet rays while heating the insulating resin 34, it is possible to stiffen in a very short time. For example, at the heating temperature of 100°C and ultraviolet ray illumination fo 500 to 1000 mW/cm$^2$, the heating time is about 0.5 to 1.0 second. Afterwards, the heating tool 40 is canceled. At this time, the LSI chip is affixed to the wiring board 32 by means of the insulating resin 34, and the bump electrode 36 of the LSI chip and conductor wiring 30 are electrically connected with each other by contact.

## Claims

1. A frabricating method of semiconductor device comprising:
a step of applying an insulating resin to a conductor wiring part of an insulation substrate having the conductor wiring;
a step of matching the conductor wiring and the electrode of the semiconductor device, pressing the semiconductor device to the applied region of the insulating resin of the insualtion substrate, and connecting the conductor wiring in the state of elastic deformation of the semiconductor device, and
a step of stiffening the insulating resin and affixing the semiconductor device to the insulation substrate, while electrically connecting the conductor wiring and the electrode of the semiconductor device.

2. A fabricating method of semiconductor device according to claim 1, wherein the electrode of the semiconductor device is a bump electrode.

3. A fabricating method of semiconductor device comprising:
a step of applying an insulating resin to a conductor wiring part of an insulation substrate having the conductor wiring;
a step of matching the conductor wiring with the electrode of the semiconductor device, pressing the semiconductor device to the applied region of the insulating resin of the insulation substrate, and contacting the electrode of the semiconductor device with the conductor wiring; and
a step of stiffening the insulating resin by irradiating with ultraviolet rays and heating at the same time to affix the semiconductor device to the insulation substrate, and electrically connecting the conductor wiring and the electrode of the semiconductor device.

4. A fabricating method of semiconductor device comprising:
a step of applying an insulating resin to a conductor wiring part of an insulation substrate having the conductor wiring;
a step of matching the conductor wiring with the electrode of the semiconductor device, pressing the semiconductor device to the applied region of the insulating resin of the insulation substrate, and contacting the conductor wiring with the electrode of the semiconductor device kept in an elastically deformed state; and
a step of stiffening the insulation resin by irradiating with ultraviolet rays and heating at the same time to affix the semiconductor device to the insulation substrate, while electrically connecting the conductor wiring and the electrode of the semiconductor device.

FIG. IA

FIG.IB

FIG.2A

FIG.2B

FIG.2C

FIG. 3A

36  38  34

30

32

FIG. 3B

40

30

38

34

36

32